# EUROPEAN PATENT SPECIFICATION

(11) **EP 3 872 504 B1**
(45) Date of publication and mention of the grant of the patent: **15.11.2023**
(21) Application number: 20159250.8
(22) Date of filing: 25.02.2020
(51) Int. Cl.: G01R 29/08, G01S 5/02

(54) **METHOD AND SYSTEM FOR MEASURING A RADIO FREQUENCY ENVIRONMENT OF A VEHICLE CABIN**
VERFAHREN UND SYSTEM ZUR MESSUNG EINER RADIOFREQUENZUMGEBUNG EINER FAHRZEUGKABINE
PROCÉDÉ ET SYSTÈME POUR MESURER UN ENVIRONNEMENT DE RADIOFRÉQUENCE D'UNE CABINE DE VÉHICULE

(43) Date of publication of application: 01.09.2021
(73) Proprietor: Rohde & Schwarz GmbH & Co. KG, 81671 München (DE)
(72) Inventor: NASEEF, Mahmud, 82152 Planegg (DE); SCHUETZE, Frederic, 85459 Berglern (DE)
(74) Representative: Isarpatent

(56) References cited:
- DE-A1-102016 005 349
- US-A1- 2016 323 048
- US-A1- 2019 113 627

## Description

### TECHNICAL FIELD

The present invention relates to a method for measuring a radio frequency environment, in particular a radio frequency environment of a vehicle cabin. The present invention further relates to a system for measuring a radio frequency environment of a vehicle cabin.

### BACKGROUND

Although applicable in principle to a measurement of radio frequency signals in any kind of cabin, in particular any kind of vehicle cabin, the present invention and its underlying problem will be hereinafter described in combination with a measurement of radio frequency signals in a cabin of a passenger car. In the context of airplanes, an exemplary method for localizing a source of interference in an interior of an airplane is known from DE 10 2016 005 349 A1.

Modern vehicles such as passenger cars or trucks, comprise a huge number of electronic devices. For example, electronic devices may be used for communication purposes, advanced driver assistance systems, controlling a drive unit or a motor of the vehicle or for controlling an entertainment system. Since the individual electronic devices may be affected by electromagnetic interferences, it will be necessary to thoroughly measure the electromagnetic waves which may have impact to the proper functionality of the electronic devices. For example, it may be necessary to identify sources of radio frequency emissions which may cause disturbances or interfere with further electronic devices.

Against this background, a problem addressed by the present invention is to provide a method and a system for measuring a radio frequency environment of a vehicle cabin. In particular, the present invention aims to provide a versatile measurement of a radio frequency environment of a vehicle cabin. Furthermore, the present invention provides a measurement of a radio frequency environment which can be easily analyzed.

### Summary

The present invention solves this object by a method and a system for measuring a radio frequency environment with the features of the independent claims. Further advantageous embodiments are subject matter of the dependent claims. According to a first aspect, a method for measuring a radio frequency (RF) environment of a vehicle cabin is provided according to independent claim 1.

According to a second aspect, a system for measuring a radio frequency (RF) environment of a vehicle cabin is provided according to independent claim 7. The memory may be further configured to store the acquired three-dimensional visual information of the vehicle cabin.

The present invention is based on the finding that a precise and fast identification of radio frequency emissions in a vehicle cabin may be of great importance for improving resistance against electromagnetic interference. By precisely locating RF sources and evaluating the signal strength of such sources, RF interferences can be easily identified. Further, it is possible to improve the overall arrangement of the electronic devices in a vehicle such that radio frequency interferences can be minimized.

The present invention therefore takes into account this finding and aims to provide a versatile and efficient measuring of an RF environment of a vehicle cabin. In particular, the present invention combines a measurement of RF signals with related visual information of the measurement arrangement, in particular the vehicle cabin. It is for this purpose that RF signals are measured and analyzed in order to determine spectral information of the measured RF signals and further to determine spatial information regarding a source emitting the measured RF signals. A direction and/or a position of a source emitting the measured RF signal is determined.

In order to improve and simplify the analysis of the RF environment of the vehicle cabin, the determined spectral information of an RF signal and the related spatial information of the source emitting the measured RF signal are set in relation to the corresponding visual information of the vehicle cabin, in particular to the acquired three-dimensional visual information of the vehicle cabin.

By combining the visual information of the vehicle cabin and the information of the measured RF signal, in particular the spectral information of the measured RF signal and the related direction/position of the source emitting the measured signal, the source emitting the respective RF signal can be easily identified. Accordingly, based on the knowledge of the spectral information and the spatial position in relation with the visual information of the vehicle cabin, an RF source causing electromagnetic interferences can be easily identified, and further measures can be applied in order to minimize electromagnetic interferences. Furthermore, by clearly knowing the position of an RF source in a vehicle cabin, a reliable basis is provided for determining whether or not such an RF source can be accepted with respect of the impact of electromagnetic interferences.

The scanning of the RF environment within the vehicle cabin may be performed, for example, by an antenna or antenna system which is configured to receive RF signals in a specific frequency range. In particular, the specific frequency range may cover a broad frequency range. Accordingly, the antenna or antenna system for measuring the RF signals may be broadband antennas. Alternatively, it may be also possible to use multiple different antennas for different frequency ranges. In this way, it is possible to cover RF signals over a broad frequency range in order to identify different kinds of RF signals. Accordingly, interfering or disturbing signals in the respective frequency range can be identified.

For example, it may be possible to use an antenna system with an antenna beam having an adjustable direction. For example, the main lobe of the antenna beam may be adapted by controllably combining signals received by multiple antenna elements. Additionally or alternatively, it may be also possible to use a mechanical positioning structure for panning or tilting the direction of an antenna. Furthermore, it may be also possible to use multiple antennas with different orientations, i.e. the main lobes of the individual antennas have different orientations. Accordingly, the direction of a received RF signal may be determined by analyzing the individual signals received by the multiple antennas having different directions. However, it is understood, that any other manner for identifying a direction or position of a received RF signal may be also possible.

The radio frequency signals which are received by the measurement device, e.g. by an antenna or antenna system, may be forwarded to an analyzing device for further analysis of the received RF signals. For example, multiple individually received RF signals may be analyzed in order to determine a direction or spatial position of an RF source emitting the received RF signal. For example, phase differences or the like of individually received signals may be analyzed, and a spatial position or at least a spatial direction of an RF source may be computed based on the phase differences of signals received by two or more antenna elements. However, it is understood, that any other kind of approach for determining a spatial position or direction of a radio frequency source with respect to the antenna or antenna system receiving the RF signals may be possible, too. Further to this, the analyzing device may process the received RF signal in order to perform a spectral analysis. For this purpose, one or more frequency components in the received RF signal may be identified. In particular, it may be possible to determine individual signal levels for each identified frequency, or to determine a signal level for a plurality of predetermined frequency ranges. Accordingly, spectral information of the received RF signal are obtained. For example, it may be possible to perform a spectral analysis over a predetermined period of time, and to determine a maximum or an average power level for the frequency components within this predetermined period of time. Additionally or alternatively, it may be also possible to acquire the spectral information over the time, i.e. to determine individual spectral information in a predetermined time grid.

The processing of the received RF signal for obtaining the spectral information may be performed, for example, by a spectrum analyzer or the like. However, any other appropriate device for generating spectral information from the received RF signal may be possible, too.

The obtained spectral information may be stored in a memory. In particular, the generated spectral information may be stored in the memory together with the corresponding spatial information of the signal source. For example, a determined spatial position or direction may be stored in the memory and this spatial information may be associated with the corresponding spectral information of the received RF signal. For this purpose, any appropriate scheme for storing the respective information may be possible.

Furthermore, visual information of the vehicle cabin is acquired. For this purpose, any kind of appropriate acquisition device such as a camera or the like may be possible. For example, it may be possible to arrange a camera at the ceiling of the vehicle cabin. Accordingly, a top-down view, preferably a wide angle top-down view can be obtained. In particular such a top-down view may be a kind of a bird eye view. However, any other appropriate position for capturing visual information of the vehicle cabin may be possible, too. For example, a 360 degree camera may be used for capturing visual information of the vehicle cabin.

In particular, the captured visual information may relate to three-dimensional visual information. Such three-dimensional visual information may relate to visual information of the vehicle cabin. Especially, the three-dimensional information may comprise spatial information of the vehicle cabin, for example a depth map or the like. Accordingly, a three-dimensional model of the interior of the vehicle cabin may be obtained based on the acquired three-dimension information. For example, the three-dimensional information may be obtained by a stereoscopic camera, a laser scanner or any other appropriate device for acquiring the three-dimensional visual information of the vehicle cabin.

Accordingly, the acquired visual information, in particular the acquired three-dimensional visual information, may be also stored in the memory. Especially, the acquired visual information may be stored in association with the acquired spectral information and the related spatial information of the RF sources. For example, the determined spatial position or direction of identified RF sources may be put in association with the respective three-dimensional visual information of the vehicle cabin. In this way, a three-dimensional model of the vehicle cabin may be obtained, wherein the obtained spectral information of an RF signal can be assigned to a related spatial position of the three-dimensional information of the vehicle cabin.

Further embodiments of the present invention are subject of further subclaims and of the following description referring to the drawings.

The method comprises a step of overlaying the determined spectral information of the measured RF signal and the acquired three-dimensional visual information of the vehicle cabin. The spectral information and the three-dimensional visual information are overlaid based on the determined direction and/or position of the source emitting the measured RF signal.

The overlaying of the spectral information and the visual information may be performed, for example, by including a representation of the determined spectral information into the acquired three-dimensional visual information of the vehicle cabin. In particular, the spectral information may be overlaid with the three-dimensional visual information such that a representation of the spectral information is included in the three-dimensional visual information at a position corresponding to the spatial position of the respective source emitting the RF signal. In this way, a representation is generated which allows a user to easily grasp the radio frequency environment of the vehicle cabin with respect to the respective spatial properties.

The method comprises a step of displaying the determined spectral information of the measured RF signal and the overlaid three-dimensional visual information of the vehicle cabin. The spectral information and the overlaid three-dimensional visual information are displayed in a virtual reality system or an augmented reality system.

By displaying the respective information in an augmented reality system, a user may wear, for example, semitransparent glasses, and the respective information may be displayed on a display of the semitransparent glasses with respect to the user's view direction. Accordingly, the user can look at a specific portion of the vehicle cabin, and the semitransparent glasses of the augmented reality system overlays additional information, in particular information relating to the spectral information of the measured RF signal. By combining the measured spectral information with the spatial information of the respective source emitting the RF signal and the additional three-dimensional information of the vehicle cabin, it is possible to provide the user with the spectral information relating to the position at which the user is looking. Additionally or alternatively, it may be also possible to use any other kind of semitransparent display for realizing an augmented reality system.

In a virtual reality system, a user is provided only with virtual visual information. For example, a user may wear a non-transparent virtual reality device. The virtual reality device may monitor motion of the user, in particular motion of the head of a user and a view direction of the user. Accordingly, the user is provided with visual information with respect to a current direction at which the user looking. In this way, a virtual representation of the vehicle cabin may be provided to a user. Further, the acquired spectral information may be included in this virtual representation of the vehicle cabin by taking into account the spatial information of the RF sources emitting the respective RF signals. Accordingly, the spectral information of measured RF signals is overlaid with this virtual representation of the vehicle cabin, wherein the virtual representation of the vehicle cabin is generated based on the acquired three-dimensional visual information of the vehicle cabin.

In a possible embodiment, the spectral information may be represented according to a predetermined color code.

For example, the predetermined color code may represent a power level or signal strength of the signals relating to the respective frequency or frequency ranges. Furthermore, it may be also possible that the color code may represent individual frequencies or frequency rages of a measured signal. However, any other kind of color code for encoding the representation of the acquired spectral information may be also possible. For example, a color code may indicate a degree of interference of a measured RF signal. For example, RF signals which may cause a critical interference may be indicated by red areas, semi-critical RF signals may be indicated by yellow areas and noncritical RF signals may be represented by green areas.

In a possible embodiment, the color code may be adapted according to a selected zoom level.

For example, an additional information may be received which may cause a zoom-in/ a zoom-out operation of the representation of the acquired spectral information in the vehicle cabin. Accordingly, in a first zoom level, a first color code may be applied, and in another zoom level, another color code may be applied. For example, in an overview, only a rough color scheme for indicating whether or not an RF signal is emitted at the respective position may be provided. In a further, more detailed zoom level, a more detailed representation, for example by separating individual frequencies or frequency ranges and/or signal levels may be represented according to a respective color code.

In a possible embodiment, the spectral information may comprise frequency information, power level information and/or time information.

As already mentioned above, the frequency information may indicate measured RF signals at specific frequencies or within specific frequency ranges. Furthermore, a power level of a received RF signal, in particular individual power levels for corresponding frequencies or frequency ranges may be provided. Furthermore, it may be possible to provide the spectral information for a specific period of time or a specific point in time. Furthermore, it may be possible to represent the spectral information in real-time. Alternatively, it may be also possible to indicate a respective point in time at which the corresponding spectral information has been acquired.

In a possible embodiment, the content of the spectral information and/or the acquired three-dimensional visual information of the vehicle cabin may be adjustable.

For example, a user may provide input to select specific properties in order to limit the content of the spectral information or the acquired three-dimensional visual information. For example, a frequency range of the spectral information may be set. Furthermore, a specific point in time or period of time may be selected and a representation of the spectral information relating to this period of time or point in time may be provided. Furthermore, it may be also possible to specify a level of detail of the visual information which may be used for overlaying the spectral information and the visual information.

In a possible embodiment, the content of the spectral information and/or the acquired three-dimensional visual information of the vehicle cabin may be adjusted based on a selected zoom level.

For example, in a first zoom level only an indication of existing RF signals at respective positions may be indicated, and in a more detailed zoom level, the spectral information may indicate frequencies or frequency ranges relating to the measured RF signal. However, any other kind of adapting the content of the spectral information and/or the three-dimensional information with respect to the zoom level may be possible, too.

With the present invention it is therefore possible to analyze a radio frequency environment, in particular a radio frequency environment in a cabin such as a vehicle cabin of a passenger car or a truck. By measuring radio frequency signals and determining the spatial position of sources emitting the respective radio frequency signals, and further combining this information with corresponding visual information, it is possible to easily analyze the radio frequency environment. Accordingly, sources which are emitting radio frequency signals, in particular sources which may cause interferences and disturbances can be easily detected, and eliminated. Accordingly, the robustness of an arrangement, in particular an arrangement of electronic components in a vehicle can be improved by identifying and adapting sources of radio frequency signals in a vehicle. In this way, the design and development of a more robust and reliable electronic system of a vehicle can be improved.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments, which are specified in the schematic figures and drawings, in which:
- Fig. 1:: shows a schematic diagram of a system for measuring a radio frequency environment;
- Fig. 2:: shows a schematic representation of RF information overlaid with visual information;
- Fig. 3:: shows a diagram indicating a representation of spectral information of an RF signal;
- Fig. 4:: shows a schematic diagram of an virtual reality arrangement for providing the spectral information overlaid with visual information; and
- Fig. 5:: shows a flow diagram illustrating a method for measuring a radio frequency environment.

The appended drawings are intended to provide further understanding of the embodiments of the invention. They illustrate embodiments and, in conjunction with the description, help to explain principles and concepts of the invention. Other embodiments and may of the advantages mentioned become apparent in view of the drawings. The elements in the drawings are not necessarily shown in scale.

In the drawings, same, functionally equivalent and identical operating elements, features and components are provided with same reference signs in each case, unless stated otherwise.

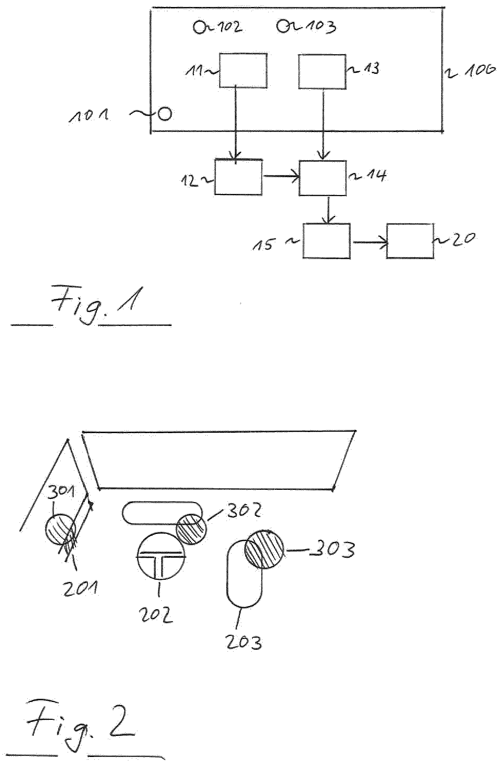

Figure 1 shows a schematic drawing of a block diagram of a system for measuring an RF environment, in particular an RF environment of a vehicle cabin 100. The vehicle cabin 100 may be, for example, a cabin of a passenger car or a truck. However, the present invention is not limited to such types of vehicle cabins 100. The system for measuring the RF environment may comprise a measuring device 11 for receiving radio frequency signals. For example, measuring device 11 may receive radio frequency signals which are emitted by emitters 111 - 113. Even though three emitters 111 - 113 are shown in figure 1, the present invention is not limited to a number of three emitters. Moreover, any other number of emitters for emitting radio frequency signals may be possible. Emitters 111 - 113 may be any kind of element which emits an RF signal. For example, emitters 111 - 113 may be a communication device for a wireless communication such as Bluetooth, WLAN or a mobile communication according to UMTS, LTE, 5G or the like. Furthermore, the emitters 111 - 113 may also comprise any other kind of electronic device causing electromagnetic signals.

Measuring device 11 may be arranged inside the vehicle cabin 100, and receive one or more electromagnetic signals. For example, measuring device 11 may comprise a number of one or more antennas or antenna elements for receiving RF signals. In particular, measuring device 11 may be an antenna or antenna system which can be tilted in order to change a direction of an antenna beam. For example, the direction of the antenna beam may be tilted by tilting the antenna or antenna system by means of a mechanical positioning structure. Additionally or alternatively, the antenna beam may be also changed electronically. Furthermore, it may be possible that the measuring device 11 comprises multiple antennas having antenna beams directing to different directions. Accordingly, by analyzing the received RF signals of the individual antennas, it may be possible determine a direction and/or spatial position of an emitter 111 - 113 emitting the respective RF signal. However, it is understood, that any other manner of receiving RF signals and determining the spatial position or direction of the respective RF source may be possible, too.

The RF signals which are received by measuring device 11 may be forwarded to an analyzing device 12. If measuring device 11 comprises multiple antennas or antenna elements, the RF signals which are received by the individual antennas or antenna elements may be forwarded to analyzing device 12 individually. Accordingly, analyzing device 12 may analyze the individual signals provided by the multiple antennas or antenna elements in order to determine a spatial position or direction of a source emitting the respective RF signals. For this purpose, phase deviations between the individual RF signals provided by the multiple antennas or antenna elements may be analyzed. However, it is understood, that any other scheme for determining a direction or spatial position of a source emitting RF signals may be possible, too.

The analyzing device 12 may further process the received RF signals from measuring device 11 in order to generate spectral information of the received RF signals. For example, analyzing device 12 may identify one or more frequency components in a received RF signal. Furthermore, it may be possible to determine an amplitude or signal strength of specific frequencies or frequency components in specific frequency ranges. For this purpose, analyzing device 12 may comprise, for example, a spectrum analyzer or the like. However, it is understood, that the processing of the received RF signals and in particular the determination of the spectral information of the received RF signals may be also performed by any other kind of appropriate device.

Accordingly, by the above described arrangement of measuring device 11 and analyzing device 12, it is possible to determine a spatial position or direction of a source emitting an RF signal and further determine the respective spectral information of the RF signal emitted by such a source. This information, i.e. the spatial position / direction and the corresponding spectral information may be stored in a memory 14. Memory 14 may be any kind of appropriate memory. In particular, memory 14 may be a non-volatile memory such as a hard disc drive, a memory card or the like. Furthermore, it may be possible to store the respective information in a memory of a cloud service or the like. For this purpose, analyzing device 12 may be connected with memory 14 via a communication network.

In addition to the scanning of the RF environment of the vehicle cabin 100 by measuring device 11 and analyzing device 12, it may be further possible to acquire visual information of the vehicle cabin 100. For example, one or more images of the vehicle cabin 100 may be captured by a camera or the like. For this purpose, an optical acquisition device 13 may be used for acquiring the respective visual information. The optical acquisition device 13 may be located, for example in a spatial position which is nearby the spatial position of measuring device 11. Furthermore, it may be possible, for example, to arrange the optical acquisition device at a ceiling of the vehicle cabin 100. However, it is understood, that any other appropriate position for arranging the optical acquisition device 13 may be possible, too. The optical acquisition device 13 may be, for example a camera, in particular a camera having a wide angle. For example, optical acquisition device 13 may comprise a 360 degree camera. By arranging the optical acquisition device 13 at the ceiling of the vehicle cabin 100, it is possible to acquire a top-down view, in particular a bird eye view of the vehicle cabin. However, any other appropriate perspective may be also possible.

Especially, it may be possible to acquire three-dimensional visual information by means of the optical acquisition device 13. For this purpose, optical acquisition device 13 may comprise a camera or camera system for acquiring visual information in a three-dimensional space surrounding the camera. In particular, it may be possible to acquire visual information and combine this visual information with further information relating to spatial positions of objects captured by the visual information. For this purpose, a stereoscopic camera or the like may be used. Additionally or alternatively, optical acquisition device 13 may comprise a laser scanner or the like for acquiring three-dimensional information. However, it is understood, that any other appropriate device or scheme for acquiring three-dimensional visual information may be also possible.

The acquired visual information, in particular the acquired three-dimensional visual information may be also stored in a memory, for example memory 14. In particular, it may be possible to store the acquired visual information in association with the spectral information of measured RF signals and the related spatial information such as the direction or position of a source emitting the measured RF signal. Accordingly, the spectral information of the measured RF signals are put in association with the corresponding visual information. In this way, it becomes easier to identify a source emitting the respective RF signal.

In order to combine the spectral information of the measured RF signal and the acquired visual information, it may be possible to overlay the spectral information of the RF signal and the acquired visual information based on the determined spatial information of the RF source emitting the measured RF signal. For example, the acquired visual information and the spectral information may be provided to a processing device 15. Accordingly, processing device 15 may generate a representation illustrating the determined spectral information of the measured RF signal by overlaying the spectral information with the visual information at a position corresponding to the spatial position of the source emitting the measured RF signal. This process of overlaying the visual information and the spectral information may be performed immediately after acquiring the respective information and before storing the information in memory 14. Alternatively, it may be also possible to store the spectral information, the spatial position of the RF sources and the acquired visual information in memory 14 and combine the information at a later point in time.

In any case, the combination of the spectral information and the visual information, in particular the overlaying of the spectral information and the visual information may be displayed on a display 20. Display 20 may be any kind of display, for example a computer monitor or the like. According to the invention, the information is provided by means of an augmented reality system and/or a virtual reality system. This will be described in more detail below.

Figure 2 shows a schematic illustration of visual information representing a part of a vehicle cabin which is overlaid with information indicating sources of RF signals. It is understood, that figure 2 shows only a schematic illustration which does not limit the scope of the present invention in any manner. For example, the vehicle cabin 100 of a vehicle may comprise a controller 201 for controlling a window opener, a steering wheel 202 and a control panel for controlling an entertainment system and/or air condition of the vehicle. However, any other elements, in particular electronic components may be also comprised in vehicle cabin 100.

When scanning the radio frequency environment of the vehicle cabin 100, one or more RF signals may be measured and a corresponding direction or spatial position of the respective RF sources may be determined. Furthermore, spectral information of the respective RF signals may be determined. Accordingly, the position of the sources of the RF signals may be illustrated in a representation overlaying the information of the RF signals and the visual information of the vehicle cabin. For example, the positions of the RF sources may be indicated by dashed areas in figure 2. For example, a first area 301 may indicate an RF signal caused by controller 201 for controlling the window opener. A second RF source 302 may be identified at the instrument panel nearby the steering wheel 202. A third RF source 303 is indicated at the panel 203 for controlling the entertainment system and the air condition.

In the above described example, the identified signal sources may be illustrated by a simple graphical element such as a circle or the like. For example, it may be possible to indicate only signal sources causing RF signals having specific properties. For example, only signals relating to a specific frequency or frequency range and/or signals having a signal power above a predetermined level or within in a specific power range may be indicated. Furthermore, it may be possible to apply a specific code, for example a color code for indicating different types of RF signals. For example, a color of the indicated RF source may change with respect to a frequency or frequency components of a corresponding RF signal. Additionally or alternatively, a color or another property of an indicated RF source may change depending on a signal strength or power level of a measured RF signal. However, any other property of a measured RF signal may be also used as a basis for applying an appropriate coding such as a color code or the like. Furthermore, it may be also possible to adapt a brightness or a thickness of lines depending on a specific property of the corresponding RF signal.

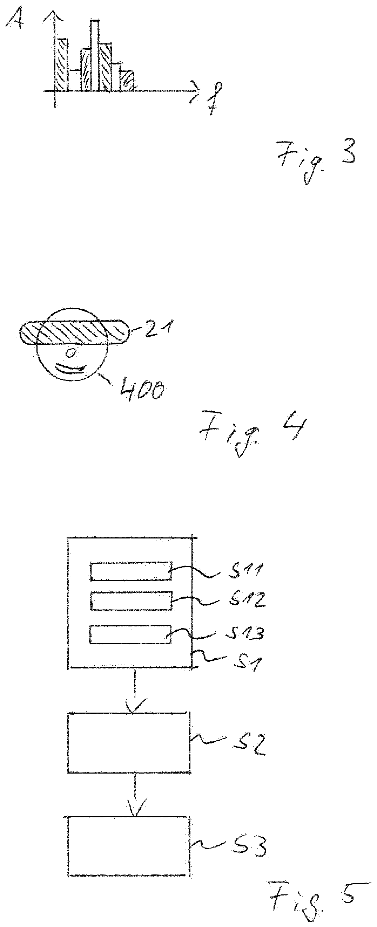

Furthermore, it may be possible to provide more detailed information of RF signals identified in the environment of the vehicle cabin 100. A further example for illustrating spectral information of a measured RF signal is shown in figure 3. As can be seen in the diagram illustrated in figure 3, it is possible to provide a diagram illustrating a power level versus the respective frequency or frequency range. For example, such diagram may be generated and overlaid with the corresponding visual information of the vehicle cabin such that the diagram is located at the position relating to the spatial position of the corresponding RF source.

For example, the type of representing the spectral information of the measured RF signals may be selected or changed depending on a user input. Furthermore, it may be also possible to automatically adapt the representation of the spectral information depending on further properties. For example, a zoom factor for illustrating the visual information may be adapted, and the representation of the overlaid spectral information may change depending on the respective zoom level. For example, if the visual information of the vehicle cabin is provided in a low zoom level, only a general indication of signal sources may be provided at the respective positions in the visual information. For example, a first color code may be applied to the indicated spectral information in this first zoom level. When a higher zoom level is applied, a more detailed representation of the spectral information may be provided at the respective positions in the visual information of the vehicle cabin 100. Accordingly, a type for providing the representation of the spectral information may change and/or another coding, in particular color coding of the spectral information may be applied depending on the zoom level. However, it is understood, that any other scheme for adapting the spectral information, in particular depending on a zoom level or another user input, may be possible, too.

As already mentioned above, the visual information and the overlaid spectral information is provided on a virtual reality system or an augmented reality system. For example, an augmented reality system may be provided, wherein the spectral information is provided by a semitransparent display. Further, a direction of view of a user may be determined, and the semitransparent display provides a representation of the determined spectral information such that the spectral information is overlaid with the corresponding position in the vehicle cabin. Furthermore, additional visual information of the vehicle cabin may be also added on the semitransparent display. The augmented reality system may comprise any kind of semitransparent display. In particular, the semitransparent display may be a device comprising semitransparent glasses and further device for determining a viewing direction of a user within the vehicle cabin.

Alternatively, the visual information of the vehicle cabin 100 and the determined spectral information may be provided in an augmented reality system as illustrated, for example in figure 4. For example, a user 400 may use a virtual reality display 21. The virtual reality display 21 may comprise a display for displaying the visual information of the vehicle cabin and the overlaid spectral information. Furthermore, the virtual reality system 21 may comprise a device for monitoring the movement of the virtual reality system 21 in a three-dimensional space. Based on the determined movement, the representation of the visual information of the vehicle cabin 100 and the overlaid spectral information is dynamically changed. In this way, a user may move around in a virtual vehicle cabin such that the determined spectral information of the RF signals are overlaid to the visual representation of the virtual vehicle cabin.

Figure 5 shows a flow diagram illustrating a method for measuring a radio frequency environment of a vehicle cabin 100. The method may comprise any kind of step for performing an operation as already described above in connection with the measurement system.

In a first step S1, a radio frequency environment of the vehicle cabin 100 is scanned. The scanning S1 of the RF environment may comprise a step S11 of measuring an RF signal, a step S12 of determining spectral information of the measured RF signal, and a step S13 of determining a direction and/or a position of a source emitting the measured RF signal.

Further, in a step S2, three-dimensional visual information of the vehicle cabin 100 is acquired. In a step S3, the determined spectral information of the measured RF signal, the related direction/position of the source emitting the measured RF signal and the acquired three-dimensional visual information of the vehicle cabin 100 is stored.

Summarizing, the present invention relates to a method and a system for measuring a radio frequency environment of a vehicle cabin. For this purpose, an RF environment of a vehicle cabin is scanned wherein spectral information of an RF signal is determined and a spatial position or direction of a source emitting the measured RF signal is determined. Further, visual information, in particular three-dimensional visual information of the vehicle cabin is acquired. The visual information of the vehicle cabin is stored together with the spectral information of the measured RF signal and the corresponding spatial information. Accordingly, the spectral information of an RF signal can be overlaid with the corresponding visual information based on the determined spatial position of the corresponding RF source. In this way, an analysis for identifying RF signals in a vehicle cabin can be simplified and improved.

## Claims

1. Method for measuring a radio frequency, RF, environment of a vehicle cabin (100), the method comprising:
scanning (S1) an RF environment of the vehicle cabin (100),
the scanning (S1) including
measuring (S11) an RF signal,
determining (S12) spectral information of the measured RF signal, and
determining (S13) a direction and/or a position of a source (101, 102, 103) emitting the measured RF signal;
acquiring (S2) three-dimensional visual information of the vehicle cabin (100); and
storing (S3) the determined spectral information of the measured RF signal, the related direction and/or position of the source (101, 102, 103) emitting the measured RF signal and the acquired three-dimensional visual information of the vehicle cabin (100) in a memory (14);
overlaying the determined spectral information of the measured RF signal and the acquired three-dimensional visual information of the vehicle cabin (100) based on the determined direction and/or position of the source (101, 102, 103) emitting the measured RF signal; and **characterised by** displaying the determined spectral information of the measured RF signal and the overlaid three-dimensional visual information of the vehicle cabin in a virtual reality system or an augmented reality system.

2. Method according to claim 1, wherein the spectral information is represented according to a predetermined color code.

3. Method according to claim 2, wherein the color code is adapted according to a selected zoom level.

4. Method according to any of claims 1 to 3, wherein the properties of the spectral information and/or the acquired three-dimensional visual information of the vehicle cabin (100) is adjustable.

5. Method of claim 4, wherein the properties of the spectral information and/or the acquired three-dimensional visual information of the vehicle cabin (100) is adjusted based on a selected zoom level for representing the visual information.

6. Method according to any of claims 1 to 5, wherein the spectral information comprises frequency information, power level information and/or time information.

7. System for measuring a radio frequency, RF, environment of a vehicle cabin (100), the system comprising:
an RF scan device configured to scan an RF environment of the vehicle cabin (100), the RF scan device comprising a measuring device (11) configured to measure an RF signal, and an analyzing device (12) configured to determine spectral information of the measured RF signal and determine a direction and/or a position of a source (101, 102, 103) emitting the measured RF signal;
an optical acquisition device (13) configured to acquire three-dimensional visual information of the vehicle cabin (100);
a memory (14) storing the determined spectral information of the measured RF signal and the related direction and/or position of the source emitting the measured RF signal;
a processing device (15) configured to overlay the determined spectral information of the measured RF signal and the acquired three-dimensional visual information of the vehicle cabin (100) based on the determined direction and/or position of the source (101, 102, 103) emitting the measured RF signal;
and **characterised by** a virtual reality system (21) or an augmented reality system configured to display the determined spectral information of the measured RF signal and the overlaid three-dimensional visual information of the vehicle cabin (100) in the virtual reality system (21) or the augmented reality system.

8. System according to claim 7, wherein the processing device (15) is configured to adapt the representation of the determined spectral information according to a predetermined color code.

9. System according to claim 7 or 8, wherein the optical acquisition device (13) comprises a camera configured to acquire a 360 degree surround-view, a top-down-view image or a stereoscopic image of the vehicle cabin (100).

10. System according to any of claims 7 to 9, wherein the measuring device (11) comprises an antenna system having a plurality of antennas, the antenna system being configured to receive RF signals from a specific direction.

## Patentansprüche

1. Verfahren zum Messen einer Hochfrequenz-Umgebung, HF-Umgebung, einer Fahrzeugkabine (100), das Verfahren umfassend:
Abtasten (S1) einer HF-Umgebung der Fahrzeugkabine (100), das Abtasten (S1) einschließlich
Messen (S11) eines HF-Signals,
Bestimmen (S12) von Spektralinformationen des gemessenen HF-Signals, und
Bestimmen (S13) einer Richtung und/oder einer Position einer Quelle (101, 102, 103), die das gemessene HF-Signal emittiert;
Erfassen (S2) von dreidimensionalen visuellen Informationen der Fahrzeugkabine (100); und
Speichern (S3) der bestimmten Spektralinformationen des gemessenen HF-Signals, der zugehörigen Richtung und/oder Position der Quelle (101, 102, 103), die das gemessene HF-Signal emittiert, und der erfassten dreidimensionalen visuellen Informationen der Fahrzeugkabine (100) in einem Speicher (14);
Überlagern der bestimmten Spektralinformationen des gemessenen HF-Signals und der erfassten dreidimensionalen visuellen Informationen der Fahrzeugkabine (100) basierend auf der bestimmten Richtung und/oder Position der Quelle (101, 102, 103), die das gemessene HF-Signal emittiert;
und **gekennzeichnet durch**
Anzeigen der bestimmten Spektralinformationen des gemessenen HF-Signals und der überlagerten dreidimensionalen visuellen Informationen der Fahrzeugkabine in einem Virtual-Reality-System oder einem Augmented-Reality-System.

2. Verfahren nach Anspruch 1, wobei die Spektralinformationen gemäß einem vorbestimmten Farbcode dargestellt werden.

3. Verfahren nach Anspruch 2, wobei der Farbcode gemäß einer ausgewählten Zoomstufe angepasst wird.

4. Verfahren nach einem der Ansprüche 1 bis 3, wobei die Eigenschaften der Spektralinformationen und/oder der erfassten dreidimensionalen visuellen Informationen der Fahrzeugkabine (100) anpassbar sind.

5. Verfahren nach Anspruch 4, wobei die Eigenschaften der Spektralinformationen und/oder der erfassten dreidimensionalen visuellen Informationen der Fahrzeugkabine (100) basierend auf einer ausgewählten Zoomstufe zum Darstellen der visuellen Informationen angepasst werden.

6. Verfahren nach einem der Ansprüche 1 bis 5, wobei die Spektralinformationen Frequenzinformationen, Leistungsstufeninformationen und/oder Zeitinformationen umfassen.

7. System zum Messen einer Hochfrequenz-Umgebung, HF-Umgebung, einer Fahrzeugkabine (100), das System umfassend:
eine HF-Abtastvorrichtung, die konfiguriert ist, um eine HF-Umgebung der Fahrzeugkabine (100) abzutasten, die HF-Abtastvorrichtung umfassend eine Messvorrichtung (11), die konfiguriert ist, um ein HF-Signal zu messen, und eine Analysevorrichtung (12), die konfiguriert ist, um Spektralinformationen des gemessenen HF-Signals zu bestimmen und eine Richtung und/oder eine Position einer Quelle (101, 102, 103) zu bestimmen, die das gemessene HF-Signal emittiert;
eine optische Erfassungsvorrichtung (13), die konfiguriert ist, um dreidimensionale visuelle Informationen der Fahrzeugkabine (100) zu erfassen;
einen Speicher (14), der die bestimmten Spektralinformationen des gemessenen HF-Signals und die zugehörige Richtung und/oder Position der Quelle speichert, die das gemessene HF-Signal emittiert;
eine Verarbeitungsvorrichtung (15), die konfiguriert ist, um die bestimmten Spektralinformationen des gemessenen HF-Signals und die erfassten dreidimensionalen visuellen Informationen der Fahrzeugkabine (100) basierend auf der bestimmten Richtung und/oder Position der Quelle (101, 102, 103) zu überlagern, die das gemessene HF-Signal emittiert;
und **gekennzeichnet durch**
ein Virtual-Reality-System (21) oder ein Augmented-Reality-System, das konfiguriert ist, um die bestimmten Spektralinformationen des gemessenen HF-Signals und die überlagerten dreidimensionalen visuellen Informationen der Fahrzeugkabine (100) in dem Virtual-Reality-System (21) oder dem Augmented-Reality-System anzuzeigen.

8. System nach Anspruch 7, wobei die Verarbeitungsvorrichtung (15) konfiguriert ist, um die Darstellung der bestimmten Spektralinformationen gemäß einem vorbestimmten Farbcode anzupassen.

9. System nach Anspruch 7 oder 8, wobei die optische Erfassungsvorrichtung (13) eine Kamera umfasst, die konfiguriert ist, um eine Rundumsicht von 360 Grad, ein Draufsichtbild oder ein stereoskopisches Bild der Fahrzeugkabine (100) zu erfassen.

10. System nach einem der Ansprüche 7 bis 9, wobei die Messvorrichtung (11) ein Antennensystem umfasst, das eine Vielzahl von Antennen aufweist, wobei das Antennensystem konfiguriert ist, um HF-Signale aus einer bestimmten Richtung zu empfangen.

## Revendications

1. Procédé permettant de mesurer un environnement radiofréquence, RF, d'une cabine de véhicule (100), le procédé comprenant :
le balayage (S1) d'un environnement RF de la cabine de véhicule (100), le balayage (S1) comportant
la mesure (S11) d'un signal RF,
la détermination (S12) d'informations spectrales du signal RF mesuré, et
la détermination (S13) d'une direction et/ou d'une position d'une source (101, 102, 103) émettant le signal RF mesuré ;
l'acquisition (S2) d'informations visuelles tridimensionnelles de la cabine de véhicule (100) ; et
le stockage (S3) des informations spectrales déterminées du signal RF mesuré, de la direction et/ou position associées de la source (101, 102, 103) émettant le signal RF mesuré et des informations visuelles tridimensionnelles acquises de la cabine de véhicule (100) dans une mémoire (14) ;
la superposition des informations spectrales déterminées du signal RF mesuré et des informations visuelles tridimensionnelles acquises de la cabine de véhicule (100) sur la base de la direction et/ou position déterminées de la source (101, 102, 103) émettant le signal RF mesuré ; et **caractérisé par** l'affichage des informations spectrales déterminées du signal RF mesuré et des informations visuelles tridimensionnelles superposées de la cabine de véhicule dans un système de réalité virtuelle ou un système de réalité augmentée.

2. Procédé selon la revendication 1, dans lequel les informations spectrales sont représentées selon un code couleur prédéterminé.

3. Procédé selon la revendication 2, dans lequel le code couleur est adapté selon un niveau de zoom sélectionné.

4. Procédé selon l'une quelconque des revendications 1 à 3, dans lequel les propriétés des informations spectrales et/ou des informations visuelles tridimensionnelles acquises de la cabine de véhicule (100) sont réglables.

5. Procédé selon la revendication 4, dans lequel les propriétés des informations spectrales et/ou des informations visuelles tridimensionnelles acquises de la cabine de véhicule (100) sont réglées sur la base d'un niveau de zoom sélectionné pour représenter les informations visuelles.

6. Procédé selon l'une quelconque des revendications 1 à 5, dans lequel les informations spectrales comprennent des informations de fréquence, des informations de niveau de puissance et/ou des informations de temps.

7. Système pour mesurer un environnement radiofréquence, RF, d'une cabine de véhicule (100), le système comprenant :
un dispositif de balayage RF configuré pour balayer un environnement RF de la cabine de véhicule (100), le dispositif de balayage RF comprenant un dispositif de mesure (11) configuré pour mesurer un signal RF, et un dispositif d'analyse (12) configuré pour déterminer des informations spectrales du signal RF mesuré et déterminer une direction et/ou une position d'une source (101, 102, 103) émettant le signal RF mesuré ;
un dispositif d'acquisition optique (13) configuré pour acquérir des informations visuelles tridimensionnelles de la cabine de véhicule (100) ;
une mémoire (14) stockant les informations spectrales déterminées du signal RF mesuré et la direction et/ou position associées de la source émettant le signal RF mesuré ;
un dispositif de traitement (15) configuré pour superposer les informations spectrales déterminées du signal RF mesuré et les informations visuelles tridimensionnelles acquises de la cabine de véhicule (100) sur la base de la direction et/ou position déterminées de la source (101, 102, 103) émettant le signal RF mesuré ;
et **caractérisé par**
un système de réalité virtuelle (21) ou un système de réalité augmentée configuré pour afficher les informations spectrales déterminées du signal RF mesuré et les informations visuelles tridimensionnelles superposées de la cabine de véhicule (100) dans le système de réalité virtuelle (21) ou le système de réalité augmentée.

8. Système selon la revendication 7, dans lequel le dispositif de traitement (15) est configuré pour adapter la représentation des informations spectrales déterminées selon un code couleur prédéterminé.

9. Système selon la revendication 7 ou 8, dans lequel le dispositif d'acquisition optique (13) comprend une caméra configurée pour acquérir une vue périphérique à 360 degrés, une image en vue de haut en bas ou une image stéréoscopique de la cabine de véhicule (100).

10. Système selon l'une quelconque des revendications 7 à 9, dans lequel le dispositif de mesure (11) comprend un système d'antenne ayant une pluralité d'antennes, le système d'antenne étant configuré pour recevoir des signaux RF à partir d'une direction spécifique.
